# EUROPÄISCHE PATENTSCHRIFT

(11) **EP 2 022 303 B1**
(45) Veröffentlichungstag und Bekanntmachung des Hinweises auf die Patenterteilung: **16.12.2009**
(21) Anmeldenummer: 07725534.7
(22) Anmeldetag: 24.05.2007
(51) Int. Cl.: H05K 13/02, H05K 13/04

(54) **ZUFÜHRVORRICHTUNG FÜR BESTÜCKUNGSMASCHINEN VON LEITERPLATTEN**
FEEDER DEVICE FOR INSERTION MACHINES FOR PRINTED CIRCUIT BOARDS
DISPOSITIF D'ALIMENTATION POUR DES MACHINES D'ÉQUIPEMENT DE CARTES DE CIRCUITS IMPRIMÉS

(30) Priorität: 26.05.2006 DE 102006024733
(43) Veröffentlichungstag der Anmeldung: 11.02.2009
(73) Patentinhaber: Maxon Motor AG, 6072 Sachseln (CH)
(72) Erfinder: FRITSCHY, Hugo, CH-6072 Sachseln (CH); TEIMEL, Arnold, CH-6064 Giswil (CH)
(74) Vertreter: Grünecker, Kinkeldey, Stockmair & Schwanhäusser Anwaltssozietät
(86) Internationale Anmeldenummer: PCT/EP2007/004637
(87) Internationale Veröffentlichungsnummer: WO 2007/137766

(56) Entgegenhaltungen:
- EP-A1- 1 324 648
- EP-A2- 0 897 258
- WO-A-03/056387
- DE-A1- 10 157 230
- JP-A- 11 171 378
- US-B1- 6 379 098

## Beschreibung

Die Erfindung betrifft einen Feedereinschub für Bestückungsmaschinen von Leiterplatten mit einem Gehäuse, einem Antriebsmotor, einem Getriebe und einem, mit einem Transportband in Eingriff stehenden Stachelrad, wobei der Antriebsmotor und das Getriebe an einer gemeinsamen Seitenwand des Gehäuses angeordnet sind, so dass ihre Achsen senkrecht zur Seitenwand stehen, der Stator direkt auf der Seitenwand des Gehäuses befestigt ist und die Seitenwand des Gehäuses zugleich die Seitenwand des Antriebsmotors bildet.

Bestückungsmaschinen werden eingesetzt, um elektronische Bauteile auf einer Leiterplatte zu positionieren. Die elektronischen Bauteile sind auf einem Transportband aus Karton oder Kunststoff angeordnet und mit einem weiteren Band abgedeckt. Das Transportband wird zu einer Rolle aufgewickelt und in einen Feeder eingesetzt. Das Transportband weist an mindestens einer Seite Löcher auf, in die ein über einen Antriebsmotor angetriebenes Stachelrad eingreift und das Transportband somit bewegt. Gleichzeitig wird die Abdeckfolie abgezogen, so dass die elektronischen Bauteile frei liegen. Die elektronischen Bauteile werden durch das Stachelrad genau an einer Übergabestelle positioniert, mit einer Vakuumpipette entnommen und auf der Leiterplatte platziert.

Da die elektronischen Bauteile immer kleiner werden und ihre Anzahl auf einer Leiterplatte kontinuierlich zunimmt, müssen moderne Bestückungsmaschinen Platz für eine möglichst große Anzahl von Feedereinschüben mit Transportbändern mit den elektronischen Bauteilen bieten. Aus Platzgründen müssen die einzelnen Feedereinschübe möglichst schmal sein.

Es ist bekannt, als Antriebsmotoren schlanke Motoren einzusetzen, deren Achsen parallel zu den Seitenwänden des Feedereinschubs verlaufen. Ein solcher konventioneller zylindrischer Antrieb muss deshalb einen sehr kleinen Durchmesser haben, d.h. er wird nur wenig Drehmoment erzeugen können, was eine hohe Untersetzung erfordert.

Es ist auch bekannt, als Antriebsmotoren flache Motoren einzusetzen, deren Achsen senkrecht zu den Seitenwänden des Feedereinschubs verlaufen. Diese Flachmotoren mit Innen- oder Außenläuferanordnung können bei geringer Bauhöhe deutlich mehr Drehmoment bereitstellen.

Ein solcher Feedereinschub ist beispielsweise aus der europäischen Patentschrift EP 0 897 258 B1 bekannt. In dieser Patentschrift wird ein Feedereinschub beschrieben, der eine an einem Hauptrahmen befestigte Bandzuführvorrichtung umfasst, die mit einem ebenfalls am Hauptrahmen befestigten Elektromotor angetrieben wird. Die Bandzuführvorrichtung bewegt das Transportband mit den elektronischen Bauteilen vorwärts, gleichzeitig wird die Abdeckfolie abgenommen. An einer Übergabeposition wird ein elektronisches Bauteil von einer Vakuumpipette angesaugt und auf einer Leiterplatte positioniert. Der Antriebsmotor ist vorzugsweise ein lmpulsmotor, über den eine genaue Positionierung der elektronischen Bauteile auf dem Transportband an der Übergabeposition erfolgen kann. Dies kann beispielsweise durch eine Änderung der Impulsanzahl oder der Impulsdauer des Impulsmotors erfolgen.

Auch in der deutschen Patentanmeldung DE 101 57 230 A1 wird ein Feedereinschub für eine Bestückungsmaschine beschrieben. Der Feedereinschub weist einen Hauptrahmen auf, an dem eine Zuführeinrichtung für ein Transportband angeordnet ist, eine Trenneinrichtung, in der die Abdeckfolie von dem Transportband abgetrennt wird und eine Rückgewinnungseinrichtung, in der die Abdeckfolie aufgewickelt wird. Der Antrieb der Zuführeinrichtung, der Trenneinrichtung und der Rückgewinnungseinrichtung erfolgt über ein Scheibenelement, das fest an einer Seite des Hauptrahmens angebracht ist und auf dem eine Vielzahl von Ankerspulen angeordnet sind. Eine Welle ist drehbar in der Mitte dieses ersten Scheibenelements gelagert. Auf der Welle ist ein zweites Scheibenelement befestigt, das mit einer kreisförmigen Permanentmagneteinrichtung verbunden ist. Über die Wechselwirkung zwischen der Permanentmagneteinrichtung und den Ankerwicklungen wird die Welle gedreht. Die Drehbewegung wird auf die Zuführeinrichtung, die Trenneinrichtung und die Rückgewinnungseinrichtung übertragen.

Ein weiterer Feedereinschub für eine Bestückungsmaschine wird in dem USamerikanischen Patent US 6,379,098 B1 offenbart. Der Feedereinschub weist einen ersten Antriebsmotor zur Fortbewegung des Transportbands auf und einen zweiten Antriebsmotor, der einen Mechanismus zum Abziehen der Abdeckfolie von dem Transportband antreibt. Der erste Antriebmotor weist einen zylindrischen Stator auf, der fest am Rahmen des Feedereinschubs befestigt ist. Ein hohlzylindrischer Rotor umgibt den Stator, wobei ein Luftspalt zwischen dem Rotor und dem Stator entsteht. Der Rotor umfasst einen hohlzylindrischen Permanentmagneten, an dessen Rückseite ein Zahnrad ausgebildet ist. In dieses Zahnrad greifen vier weitere Zahnräder ein, die den Rotor in seiner Position halten.

Nachteilig an diesem aus dem Stand der Technik bekannten Feedereinschüben ist zum Einen, dass die Dicke der Feedereinschübe durch die Länge der Antriebsmotoren sowie die Dicke der Gehäusewände von Motor und Feedereinschub festgelegt ist. In dem in dem US-Patent 6,379,098 B1 beschriebenen Feedereinschub wird versucht diesen Nachteil dadurch zu beheben, dass der Antriebsmotor keine Motorwelle aufweist, sondern der Rotor über vier Zahnräder gelagert wird. Dadurch wird die Montage des Systems relativ komplex.

Es ist daher Aufgabe der vorliegenden Erfindung einen Feedereinschub bereitzustellen, dessen Dicke weiter reduziert werden kann, der über einen einfachen Aufbau verfügt und daher eine einfache Montage ermöglicht.

Hierzu ist erfingdungsgemäß vorgesehen, dass der Rotor des Antriebsmotors drehbar ausschließlich auf einer Achse gelagert ist, die fest mit der Seitenwand des Gehäuses verbunden ist.

Durch die Lagerung des Rotors des Antriebsmotors auf einer Achse in der Seitenwand des Gehäuses kann die Basisplatte des Motors mit Lagern eingespart werden. Somit ist eine weitere Reduktion der Dicke möglich. Durch die Lagerung des Rotors ausschließlich auf einer Achse ist eine einfache Montage möglich. Der Rotor erhält dadurch seine Kippstabilität, dass die Achse die Seitenwand vollständig oder auf einem möglichst langen Abschnitt durchdringt. Der Rotor kann auf der Achse durch eine Gleitlagerung oder durch Wälzlager gelagert werden.

Bei einer vorteilhaften Ausführungsform ist vorgesehen, dass in der Seitenwand des Gehäuses eine Hülse angeordnet ist, in der die Achse des Antriebsmotors eingepresst ist. Es steht also eine größere Fläche zur Lagerung der Achse des Antriebsmotors zur Verfügung. Die Kippstabilität der Achse wird dadurch noch weiter erhöht. In diesem Zusammenhang ist es auch günstig, wenn die Hülse einen Auflageflansch aufweist, mit dem die Hülse an der Seitenwand anliegt.

Um einen festen Halt der Hülse in der Seitenwand des Gehäuses zu ermöglichen, kann die Hülse vorteilhafter Weise in die Seitenwand des Gehäuses eingepresst werden.

Gemäß einer weiteren Ausführungsform kann vorgesehen werden, dass die Seitenwand des Gehäuses weitere Bohrungen aufweist, in denen die Getriebeachsen angeordnet sind. Auch auf diese Weise wird eine Reduzierung der Dicke des Feederantriebs ermöglicht. Durch die Lagerung der Rotorachse und der Getriebeachsen in der Seitenwand des Gehäuses können Montageungenauigkeiten, die beim Anbringen separater Bauteile auf die Seitenwand entstehen, vermieden werden.

Eine weitere Variante der Erfindung sieht vor, dass auf dem Stachelrad ein Encoder zur Positionierung des Transportbands angeordnet ist. Damit ist eine sehr hohe Positioniergenauigkeit des Feeders möglich.

Vorteilhafterweise kann der Encoder als inkrementaler Drehgeber ausgebildet sein, dessen Impulszahl mit der Anzahl der Übergabepositionen identisch ist.

Es kann auch vorgesehen werden, dass der Encoder auf dem Stachelrad ein inkrementaler Drehgeber ist, dessen Impulszahl ausreichend groß für einen Servobetrieb des Antriebsmotors und eine genaue Positionierung des Stachelrads ist. Es wird also nur ein Sensorsystem benötigt.

Günstig ist auch, wenn zusätzlich ein weiteres Gebersystem vorgesehen ist, welches nicht zwingend auf dem gleichen physikalischen Prinzip (optisch, induktiv, kapazitiv) beruhen muss wie der Inkrementalgeber. Mit diesen zusätzlichen Gebersystem lässt sich ein Referenzimpuls zur Bestimmung der Absolutposition erzeugen.

Alternativ kann der Encoder vorteilhaft auch ein Absolut-Drehgeber sein, der nach dem Einschalten und zu jeder Zeit die Absolutposition mit einer der Aufgabe entsprechenden Genauigkeit zur Verfügung stellt.

Eine weitere Variante sieht vor, dass zusätzlich zu dem Absolutdrehgeber ein inkrementaler Drehgeber vorgesehen ist. Über den Absolutdrehgeber kann dann die Winkelstellung des Stachelrades bestimmt werden, die Positionierung des Stachelrads kann über den inkrementalen Drehgeber durchgeführt werden.

Hierzu ist die Impulszahl des inkrementalen Drehgebers vorteilhafter Weise mit der Anzahl an Übergabepositionen identisch. Es kann aber auch vorgesehen werden, dass die Impulszahl des inkrementalen Drehgebers ausreichend groß für einen Servobetrieb des Antriebsmotors und eine genaue Positionierung des Stachel rads ist.

Zudem kann vorgesehen werden, dass weitere mechanische Übertragungselemente vorgesehen sind, die den Antriebsmotor mit einer auf dem Transportband angeordneten Abdeckfolie verbinden. Es ist daher nur ein Antriebsmotor notwendig, um das Transportband zu bewegen und die auf dem Transportband angeordnete Abdeckfolie abzuziehen.

Zweckmäßiger Weise hat der Encoder Zugriff auf eine Korrekturtabelle, in der bei einem Kalibriervorgang ermittelte geometrische Abweichungen einzelner Zähne des Stachelrads abgelegt sind. Somit ist eine genaue Positionierung des Stachelrads an den Übergabestellen möglich.

Im Folgenden wird eine Ausführungsform der Erfindung anhand einer Zeichnung näher erläutert. Es zeigen:
- Fig. 1: Seitenansicht eines Feedereinschubs,
- Fig. 2: Schnitt durch einen Antriebsmotor für einen Feedereinschub, entlang der Li- nie II-II aus Fig.1 und
- Fig. 3: Schnitt durch eine alternative Ausführungsform eines Antriebsmotors entlang der Linie II-II aus Fig. 1

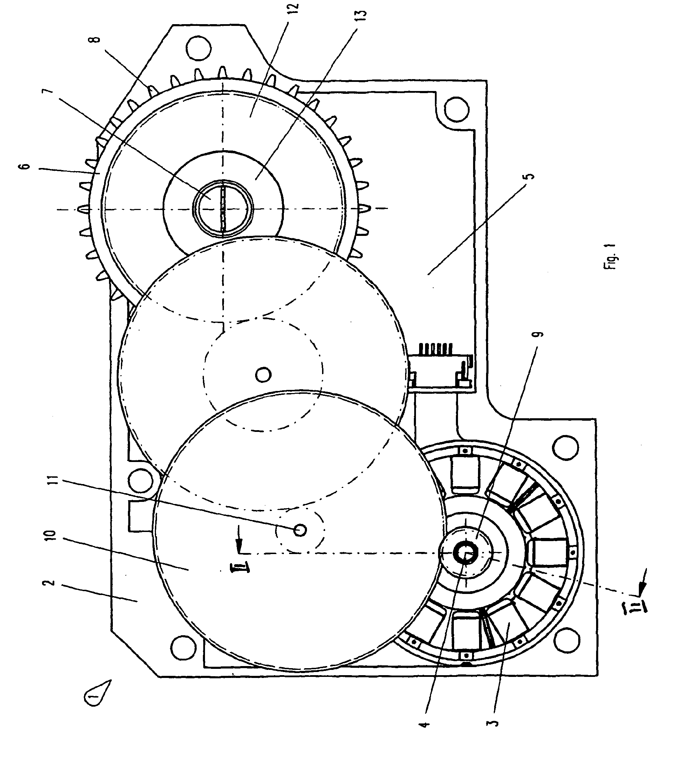

Fig. 1 zeigt eine Seitenansicht eines Feedereinschubs 1. Der Feedereinschub 1 weist ein Gehäuse mit einer Seitenwand 2 auf. Auf der Seitenwand 2 ist ein Flachmotor 3 befestigt. Um die Dicke des Feedereinschubs 1 zu reduzieren, ist der Flachmotor 3 so am Gehäuse des Feedereinschubs 1 befestigt, dass die Rotorachse 4 des Flachmotors 3 senkrecht zur Gehäusewand 2 verläuft.

Der Flachmotor 3 kann dazu genutzt werden, ein Transportband anzutreiben, auf dem elektronische Bauteile angeordnet sind, die vom Feeder zur Platzierung auf einer Leiterplatte bereitgestellt werden. Der Flachmotor 3 kann aber auch dazu dienen, eine auf dem Transportband angeordnete Abdeckfolie, mit der die elektronischen Bauteile geschützt werden, von dem Transportband abzuziehen, um Zugriff auf die elektronischen Bauteile zu ermöglichen. Dazu sind in dem Feedereinschub geeignete Übertragungselemente vorgesehen, die die Bewegung des Flachmotors auf die Abdeckfolie übertragen. Es ist auch möglich, dass der Flachmotor 3 beide Funktionen erfüllt. Der Flachmotor übernimmt dann sowohl die Funktion des Transportbandantriebs als auch des Folienabzuges, ein zusätzlicher Motor kann eingespart werden.

Im Folgenden wird beschrieben, dass der Flachmotor 3 als Antrieb für das Transportband benutzt wird.

In diesem Fall ist der Flachmotor 3 über eine Getriebeeinheit 5 mit dem Stachelrad 6 verbunden. Das Stachelrad 6 ist ebenfalls auf einer senkrecht zur Seitenwand 2 verlaufenden Achse 7 gelagert. Über das Stachelrad 6 wird das Transportband angetrieben. Dazu weist das Stachelrad 6 an seinem Umfang Zähne bzw. Stachel 8 auf. Das Transportband ist an mindestens einem Rand mit Öffnungen versehen, ähnlich wie ein Film für einen Fotoapparat. Die Stachel 8 des Stachelrads 6 greifen in diese Öffnungen des Transportbands ein und ziehen das Transportband mit sich.

Auf dem Rotor 14 des Flachmotors 3 ist ein Zahnrad 9 angeordnet. Das Zahnrad 9 steht mit einem Zahnrad 10 der Getriebeeinheit 5 in Eingriff. Das Zahnrad 10 ist auf einer Getriebeachse 11 gelagert, die ebenfalls senkrecht zur Seitenwand 2 verläuft. Je nach benötigter Übersetzung weist die Getriebeeinheit 5 weitere auf senkrecht zur Seitenwand verlaufenden Getriebeachsen gelagerte Zahnräder auf. Auch auf der Achse 7 des Stachelrads 6 ist ein Zahnrad 12 angebracht. Die letzte Stufe der Getriebeeinheit 5 steht mit diesem Zahnrad 12 in Eingriff und überträgt die Kraft des Antriebsmotors 3 auf das Stachelrad 6.

Um die auf dem Transportband angeordneten elektronischen Bauteile an den Übergabepositionen für den Bestückungskopf genau zu positionieren, ist direkt am Stachelrad 6 ein Positionserkennungssystem angeordnet. In der beschriebenen Ausführungsform ist dazu an dem Stachelrad 6 die Codescheibe 13 eines Encoders angebracht. Der Encoder ermöglicht es, die geometrische Abweichung einzelner Zähne des Stachelrads 6 über einen Kalibriervorgang zu kompensieren. Dazu wird das Stachelrad 6 mit einem hochpräzisen Referenzsystem vermessen und die Korrekturwerte werden in einer Datentabelle abgelegt.

Das eingesetzte Encodersystem kann auf einem induktiven, einem kapazitiven, einem magnetischen oder einem optischen Funktionsprinzip basieren. Bei dem Encoder kann es sich um einen inkrementalen Drehgeber handeln. Die Anzahl der Impulse des inkrementalen Drehgebers entsprechen dann der Anzahl der Übergabepositionen am Stachelrad. Um die Encodersignale mit einer zuvor erstellten Korrekturtabelle mit den geometrischen Abweichungen des Stachelrades abzugleichen, verfügt das inkrementale Encodersystem über einen Referenzimpuls. Dieser Referenzimpuls kann wahlweise durch einen zusätzlichen Sensor, der auf einem anderen Funktionsprinzip als der inkrementalen Encoder basiert, erzeugt werden. Hierbei ist nachteilig, dass unter ungünstigen Bedingungen eine nahezu vollständige Umdrehung des Stachel rads nötig ist, bis das Signal zur Initialisierung der Zuordnung der Position zur Korrekturtabelle ansteht. In diesem Fall würden elektronischen Bauteile, die während dieser Umdrehung zur Bestückung anstehen, ungenutzt verloren gehen.

Es kann auch ein Encodersystem eingesetzt werden, das durch eine oder mehrere zusätzliche Spuren nicht nur die inkrementale, sondern auch die absolute Winkelposition bereitstellt. Bei diesem absoluten Encodersystem ist die Anzahl der zu Verfügung stehenden Absolutpositionen mindestens genauso groß wie die Anzahl der Übergabepositionen am Stachelrad. Damit ist eine direkte Zuordnung zur Korrekturtabelle an jeder Übergabeposition möglich. Es muss damit kein Referenzpunkt mehr angefahren werden, wodurch kein Verlust von Bauteilen mehr entsteht.

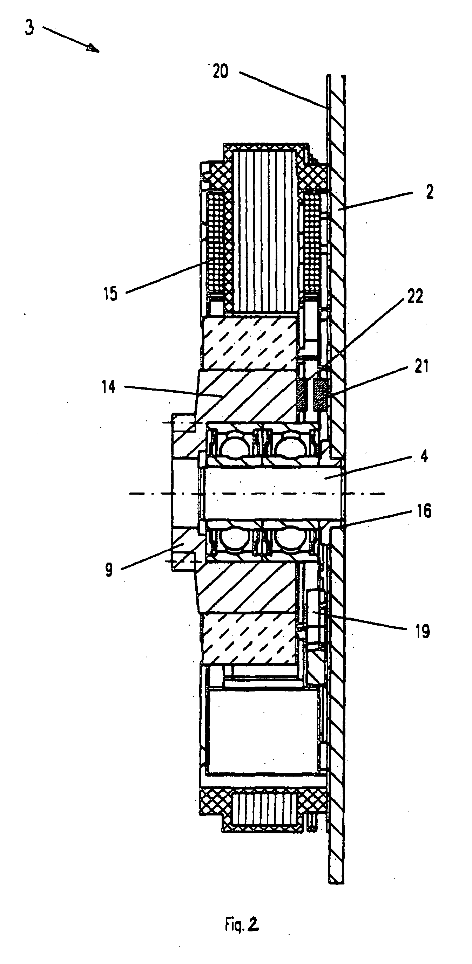

In Fig. 2 ist ein Querschnitt durch einen Flachmotor 3 dargestellt, der in einen Feedereinschub eingesetzt werden kann. Der Motor 3 umfasst einen Rotor 14 und einen Stator 15, der auf einer Bodenplatte 2 befestigt ist. Der Rotor 14 ist auf Außenringen der die Rotorachse 4 umgebenden Kugellager montiert. Auf der Oberseite des Rotors 14 befindet sich das Ritzel 9 für die Übertragung der Rotordrehung auf das Getriebe. Der Stator 15 mit seiner Wicklung ist am Außenumfang des Rotors 14 angeordnet. Dieser Aufbau hat den Vorteil einer deutlich geringeren Rotorträgheit gegenüber einer Außenläuferanordnung und ist deshalb bei hohen dynamischen Anforderungen vorteilhafter. Um einen flachen Aufbau des Feedereinschubs 1 zu ermöglichen, bildet die Seitenwand 2 des Feedereinschubs die Bodenplatte des Motors 3. In der Seitenwand 2 des Gehäuses ist eine Hülse 16 eingepresst, in die wiederum die Rotorachse 4 des Flachmotors 3 eingepresst ist. Dazu weist die Seitenwand 2 eine Bohrung auf, in die eine Hülse 16 soweit eingepresst ist, bis sie mit einem Auflageflansch an der Seitenwand 2 anliegt. Auf der Rotorachse 4 ist der Rotor 14 drehbar gelagert. Eine Drehung des Rotors 14 führt somit zur Drehung des Zahnrades 9.

Alternativ kann die Verbindung zwischen der Rotorachse 4 und der Hülse 16 bzw. der Seitenwand 2 und/oder die Verbindung zwischen der Hülse 16 und der Seitenwand 2 durch Schweißen, beispielsweise durch Laserschweißen, erfolgen.

Um die Position des Rotors 14 zu bestimmen, werden Sensoren 19 eingesetzt. Die Sensoren 19 befinden sich unter dem Magneten des Rotors 14 und tasten dessen Magnetfeld ab. Bei den Sensoren kann es sich um Hall IC's mit digitalem Ausgang oder um lineare Hallsensoren mit analogem Ausgang handeln. Werden lineare Hallsensoren eingesetzt, können durch eine zusätzliche Elektronik aus 2 um 90° elektrisch versetzten Sensoren ein Encodersignal und die Kommutierungssignale gewonnen werden. Das gleiche Ergebnis kann mit einer etwas anderen Auswerteelektronik mit 3 um 120° elektrisch versetzten Sensoren erreicht werden. Weiterhin ist es auch möglich, eine optische oder magnetische Encoderscheibe 22 am Rotor 14 anzubringen. Diese Encoderscheibe kann mit optischen oder magnetischen Sensoren 21 abgetastet werden, die auf der Leiterplatte 20 angeordnet sind, wodurch eine höhere Winkelauflösung erreicht werden kann. Wird ein magnetisches System eingesetzt, so erzeugen die Hall-Sensoren 19 zusätzliche Signale für die Kommutierung des Motors.

Die Kontaktierung der Wicklungsanschlüsse des Stators 15 und der Sensoren 19 erfolgt über eine flache, aus Gründen einer minimalen Bauhöhe bevorzugt flexiblen Leiterplatte 20 mit einer Folie (z.B. aus Kapton) als Trägermaterial, die auf der Seitenwand 2 angebracht ist.

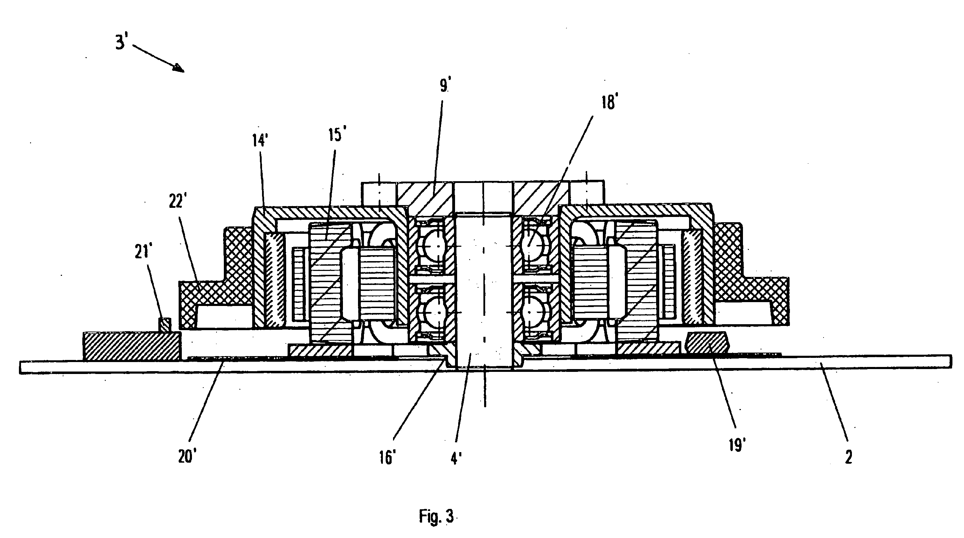

Fig. 3 zeigt eine alternative Ausführungsform eines Flachmotors 3'. Trotz der oben genannten Nachteile kann der Flachmotor 3' auch als Außenläufermotor ausgebildet sein. Der Flachmotor 3' umfasst wiederum einen Rotor 14' und einen Stator 15'. Der Stator 15' ist auf der Bodenplatte 2 befestigt, die gleichzeitig die Seitenwand 2 des Gehäuses bildet. Die Bodenplatte bzw. Seitenwand 2 weist eine Bohrung auf, in die eine Hülse 16' mit einem Auflageflansch eingepresst ist. Die Rotorachse 4' ist wiederum in diese Hülse 16' eingepresst. Alternativ kann die Rotorachse 4' durch Schweißen, beispielsweise Laserschweißen, in der Seitenwand 2 oder der Hülse befestigt werden. Auch die Hülse könnte durch Schweißen in der Seitenwand befestigt werden.

Auf der Rotorachse 4' sind Kugellager 18' montiert. Auf den Außenringen der Kugellager 18' ist der Rotor 14' angeordnet.

Der Rotor 14' ist mit einem Ritzel 9' verbunden, das die Rotationsbewegung des Rotors 14' an das Getriebe 5 weiterleitet.

An dem Flachmotor 3' kann ferner ein zusätzliches Encodersystem angebracht werden. Es kann sich dabei um ein optisches Encodersystem handeln, bei dem der Codeträger 22' am Rotor 14' befestigt ist und der Sensor 21' auf der Grundplatte 2.

Es ist aber auch möglich, ein magnetisches Encodersystem einzusetzen. In diesem Fall detektieren zwei oder drei Sensoren 19' das Magnetfeld des Rotors 14'. Eine spezielle Elektronik wandelt Signale der Sensoren 19' um in Encodersignale für die Positionierung des Stachelrads 6 und in Signale für die Kommutierung des Flachmotors 3'.

Eine andere Alternative ist ein weiteres magnetisches Encodersystem. In diesem Encodersystem ist ein spezieller Sensor 21' vorgesehen, der einen eigenständigen, am Rotor 14' befestigten magnetischen Codeträger 22' detektiert. Zusätzlich sind auf der Leiterplatte 20' für den Flachmotor 3' Hall-Sensoren 19' vorgesehen, die Signale für die Kommutierung des Flachmotors 3' erzeugen.

Sowohl bei dem Einsatz eines Innenlaufermotors 3 als auch beim Einsatz eines Außenläufermotors'3' kann das auf dem Rotor 14, 14' angeordnete Encodersystem zur Positionierung des Stachelrads 6 genutzt werden. Durch die Untersetzung des Getriebes 5 ist dann nur eine geringere Auflösung des Encoders für die Positionierung des Stachelrads notwendig, die Anforderungen an die Qualität des Encodersystems sind niedriger. Dieses Encodersystem dient auch für den Servobetrieb des Motors 3, 3'.

Es kann jedoch auch das auf dem Stachelrad 6 angeordnete hochauflösende Encodersystem zur Positionierung des Stachelrads 6 eingesetzt werden.

Eine weitere Möglichkeit besteht darin, die Signale für die Kommutierung des Flachmotors sensorlos über ein in den Flachmotor integriertes Messsystem zu erzeugen. Dieses Messsystem ermittelt hochauflösende Positionsinformation aus der variablen Induktivität und/oder EMK-Rückwirkung des Flachmotors. Das Messsystem kann in die vorhandene Motorsteuerung integriert werden. Es wäre auch möglich, die durch das in den Flachmotor integrierte Messsystem ermittelte Positionsinformation zur Positionierung des Stachelrads einzusetzen. Aufgrund der Untersetzung des Getriebes zwischen dem Flachmotor und dem Stachelrad kann eine sehr große Auflösung am Stachelrad erreicht werden.

Die Seitenwand 2 weist weitere Bohrungen auf, in denen die Getriebeachsen angeordnet sind. Dadurch werden weitere Montagetoleranzen vermieden, die die Genauigkeit der Übertragung der Bewegung des Motors durch das Getriebe negativ beeinflussen.

## Patentansprüche

1. Feedereinschub (1) für Bestückungsmaschinen von Leiterplatten mit einem Gehäuse, einem Antriebsmotor (3, 3'), einem Getriebe (5) und einem, mit einem Transportband in Eingriff stehenden Stachelrad (6), wobei der Antriebsmotor (3, 3') und das Getriebe (5) an einer gemeinsamen Seitenwand (2) des Gehäuses angeordnet sind, so dass ihre Achsen senkrecht zur Seitenwand (2) stehen, der Stator (15, 15') direkt auf der Seitenwand (2) des Gehäuses befestigt ist und die Seitenwand (2) des Gehäuses zugleich die Seitenwand (2) des Antriebsmotors (3) bildet, **dadurch gekennzeichnet, dass** der Rotor (14, 14') des Antriebsmotors (3) drehbar ausschließlich auf einer Achse (4, 4') gelagert ist, die fest mit der Seitenwand (2) des Gehäuses verbunden ist.

2. Feedereinschub (1) nach Anspruch 1, **dadurch gekennzeichnet, dass** der Rotor (14) des bürstenlosen Antriebsmotors (3) permanenterregt ist und innerhalb des Stators (15) liegt.

3. Feedereinschub nach Anspruch 1 oder 2, **dadurch gekennzeichnet, dass** die feste Verbindung zwischen Achse (4) und Seitenwand (2) des Gehäuses durch eine Hülse (16) erreicht wird.

4. Feedereinschub (1) nach Anspruch 3, **dadurch gekennzeichnet, dass** die Hülse (16) in die Seitenwand (2) des Gehäuses eingepresst ist.

5. Feedereinschub nach einem der Ansprüche 3 oder 4, **dadurch gekennzeichnet, dass** die Achse (4) in die Hülse (16) eingepresst ist.

6. Feedereinschub (1) nach einem der Ansprüche 3 bis 5, **dadurch gekennzeichnet, dass** die Hülse (16) einen Anlageflansch aufweist, mit dem die Hülse an der Seitenwand (2) des Gehäuses anliegt.

7. Feedereinschub nach mindestens einem der vorhergehenden Ansprüche, **dadurch gekennzeichnet, dass** auf dem Rotor (14, 14') des Antriebsmotors (3, 3') an einer Seite ein Ritzel (9, 9') zur Übertragung des Drehmoments auf ein Getriebe befestigt ist.

8. Feedereinschub nach mindestens einem der vorhergehenden Ansprüche, **dadurch gekennzeichnet, dass** die Seitenwand (2) weitere Bohrungen aufweist, in denen die Achsen für Getriebestufen (11) befestigt werden.

9. Feedereinschub nach mindestens einem der vorhergehenden Ansprüche, **dadurch gekennzeichnet, dass** auf dem Stachelrad (6) ein Encoder (13) zur Positionierung des Transportbandes angeordnet ist.

10. Feedereinschub nach Anspruch 9, **dadurch gekennzeichnet, dass** der Encoder (13) auf dem Stachelrad (6) ein inkrementaler Drehgeber ist, dessen Impulszahl mit der Anzahl Übergabepositionen identisch ist.

11. Feedereinschub nach Anspruch 9, **dadurch gekennzeichnet, dass** der Encoder (13) auf dem Stachelrad (6) ein inkrementaler Drehgeber ist, dessen Impulszahl ausreichend groß für einen Servobetrieb des Antriebmotors (3, 3') und eine genaue Positionierung des Stachelrads (6) ist.

12. Feedereinschub nach einem der Ansprüche 9 bis 11, **dadurch gekennzeichnet, dass** zusätzlich ein weiteres Gebersystem zur Erzeugung eines Referenzimpulses zur Bestimmung der Absolutposition des Stachelrads (6) vorgesehen ist.

13. Feedereinschub nach Anspruch 9, **dadurch gekennzeichnet, dass** der Encoder (13) ein Absolut-Drehgeber ist, der nach Einschalten zu jeder Zeit die Absolutposition zur Verfügung stellt.

14. Feedereinschub nach Anspruch 13, **dadurch gekennzeichnet, dass** zusätzlich zu dem Absolut-Drehgeber ein inkrementaler Drehgeber vorgesehen ist.

15. Feedereinschub nach Anspruch 14, **dadurch gekennzeichnet, dass** die Impulszahl des inkrementalen Drehgebers mit der Anzahl Übergabepositionen identisch ist.

16. Feedereinschub nach Anspruch 14, **dadurch gekennzeichnet, dass** die Impulszahl des inkrementalen Drehgebers ausreichend groß für einen Servobetrieb des Antriebsmotors (3, 3') und eine genaue Positionierung des Stachelrads (6) ist.

17. Federeinschub nach einem der Ansprüche 1 bis 16, **dadurch gekennzeichnet, dass** weitere mechanische Übertragungselemente vorgesehen sind, die den Antriebsmotor (3, 3') mit einer auf dem Transportband angeordneten Abdeckfolie verbinden.

18. Feedereinschub nach Anspruch 9, **dadurch gekennzeichnet, dass** der Encoder Zugriff auf eine Korrekturtabelle hat, in der bei einem Kalibriervorgang ermittelte geometrische Abweichungen einzelner Zähne des Stachelrads abgelegt sind.

## Claims

1. A feeder device (1) for insertion machines for printed circuit boards, comprising a housing, a drive motor (3, 3'), a gear unit (5) and a pin wheel (6) engaging with a transport tape, said drive motor (3, 3') and said gear unit (5) being arranged on a common side wall (2) of the housing such that the axles thereof are perpendicular to the side wall (2), the stator (15, 15') being secured directly to the side wall (2) of the housing, and said side wall (2) of the housing defining simultaneously the side wall (2) of the drive motor (3), **characterized In that** the rotor (14, 14') of the drive motor (3) is rotatably mounted on only one axle (4, 4') which is fixedly connected to the side wall (2) of the housing.

2. A feeder device according to claim 1, **characterized In that** the rotor (14) of the brushless drive motor (3) is permanently excited and positioned within the stator (15).

3. A feeder device according to claim 1 or 2, **characterized In that** the fixed connection between the axle (4) and the side wall (2) of the housing is accomplished by a sleeve (16).

4. A feeder device according to claim 3, **characterized In that** the sleeve (16) is press-fitted in the side wall (2) of the housing.

5. A feeder device according to one of the claims 3 or 4, **characterized in that** the axle (4) is press-fitted in the sleeve (16).

6. A feeder device according to one of the claims 3 to 5, **characterized In that** the sleeve (16) is provided with a support flange with which said sleeve abuts on the side wall (2) of the housing.

7. A feeder device according to at least one of the preceding claims, **characterized In that** a pinion (9, 9') for transmitting the torque to a gear unit is secured in position on one side of the rotor (14, 14') of the drive motor (3, 3').

8. A feeder device according to at least one of the preceding claims, **characterized In that** the side wall (2) is provided with additional holes in which gear stage axles (11) are secured in position.

9. A feeder device according to at least one of the preceding claims, **characterized In that** the pin wheel (6) has arranged thereon an encoder (13) for positioning the transport tape.

10. A feeder device according to claim 9, **characterized In that** the encoder (13) on the pin wheel (6) is an incremental rotary encoder whose number of pulses is identical with the number of transfer positions.

11. A feeder device according to claim 9, **characterized In that** the encoder (13) on the pin wheel (6) is an incremental rotary encoder whose number of pulses is sufficiently large for a servo operation of the drive motor (3, 3') and a precise positioning of the pin wheel (6).

12. A feeder device according to one of the claims 9 to 11, **characterized In that** an additional encoder system is provided for producing a reference pulse for determining the absolute position of the pin wheel (6).

13. A feeder device according to claim 9, **characterized In that** the encoder (13) is an absolute rotary encoder which, after having been switched on, provides the absolute position at any time.

14. A feeder device according to claim 13, **characterized In that** an incremental rotary encoder is provided in addition to the absolute rotary encoder.

15. A feeder device according to claim 14, **characterized In that** the number of pulses of the incremental rotary encoder is identical with the number of transfer positions.

16. A feeder device according to claim 14, **characterized in that** the number of pulses of the incremental rotary encoder is sufficiently large for a servo operation of the drive motor (3, 3') and a precise positioning of the pin wheel (6).

17. A feeder device according to one of the claims 1 to 18, **characterized In that** additional mechanical transmission elements are provided, which connect the drive motor (3, 3') to a cover sheet arranged on the transport tape.

18. A feeder device according to claim 9, **characterized in that** the encoder is able to access a correction table having stored therein geometric deviations of individual teeth of the pin wheel which have been ascertained during a calibration process.

## Revendications

1. Dispositif d'alimentation enfichable (1) pour des machines de garnissage de cartes imprimées, avec un carter, un moteur d'entraînement (3, 3'), une transmission (5) et une roue à picots (6) en prise avec un convoyeur à bande, étant précisé que le moteur d'entraînement (3, 3') et la transmission (5) sont disposés sur une paroi latérale commune (2) du carter, de sorte que leurs axes sont perpendiculaires à ladite paroi latérale (2), que le stator (15, 15') est fixé directement sur la paroi latérale (2) du carter et que la paroi latérale (2) du carter forme en même temps la paroi latérale (2) du moteur d'entraînement (3), **caractérisé en ce que** le rotor (14, 14') du moteur d'entraînement (3) est monté en rotation uniquement sur un axe (4, 4') qui est solidaire de la paroi latérale (2) du carter.

2. Dispositif d'alimentation enfichable (1) selon la revendication 1, **caractérisé en ce que** le rotor (14) du moteur d'entraînement sans balais (3) est excité en permanence et se trouve à l'intérieur du stator (15).

3. Dispositif d'alimentation enfichable selon la revendication 1 ou 2, **caractérisé en ce que** la liaison fixe entre l'axe (4) et la paroi latérale (2) du carter est obtenue grâce à un manchon (16).

4. Dispositif d'alimentation enfichable (1) selon la revendication 3, **caractérisé en ce que** le manchon (16) est enfoncé dans la paroi latérale (2) du carter.

5. Dispositif d'alimentation enfichable selon l'une des revendications 3 ou 4, **caractérisé en ce que** l'axe (4) est enfoncé dans le manchon (16).

6. Dispositif d'alimentation enfichable (1) selon l'une des revendications 3 à 5, **caractérisé en ce que** le manchon (16) présente une bride d'application avec laquelle il est appliqué contre la paroi latérale (2) du carter.

7. Dispositif d'alimentation enfichable selon l'une au moins des revendications précédentes, **caractérisé en ce qu'**un pignon (9, 9') est fixé sur le rotor (14, 14') du moteur d'entraînement (3, 3'), sur un côté, pour transmettre le couple à une transmission.

8. Dispositif d'alimentation enfichable selon l'une au moins des revendications précédentes, **caractérisé en ce que** la paroi latérale (2) présente des perçages supplémentaires dans lesquels sont fixés les axes pour des niveaux de transmission (11).

9. Dispositif d'alimentation enfichable selon l'une des revendications précédentes, **caractérisé en ce qu'**un codeur (13) est disposé sur la roue à picots (6), pour positionner le convoyeur à bande.

10. Dispositif d'alimentation enfichable selon la revendication 9, **caractérisé en ce que** le codeur (13) prévu sur la roue à picots (6) est constitué par un capteur de rotation incrémentiel dont le nombre d'impulsions est identique au nombre de positions de transfert.

11. Dispositif d'alimentation enfichable selon la revendication 9, **caractérisé en ce que** le codeur (13) prévu sur la roue à picots (6) est constitué par un capteur de rotation incrémentiel dont le nombre d'impulsions est suffisamment grand pour un servo-fonctionnement du moteur d'entraînement (3, 3') et pour un positionnement précis de la roue à picots (6).

12. Dispositif d'alimentation enfichable selon l'une des revendications 9 à 11, **caractérisé en ce qu'**il est prévu en supplément un autre système de capteur pour produire une impulsion de référence afin de définir la position absolue de la roue à picots (6).

13. Dispositif d'alimentation enfichable selon la revendication 9, **caractérisé en ce que** le codeur (13) est constitué par un capteur de rotation absolu qui, après la mise en marche, fournit à tout moment la position absolue.

14. Dispositif d'alimentation enfichable selon la revendication 13, **caractérisé en ce qu'**il est prévu, en plus du capteur de rotation absolu, un capteur de rotation incrémentiel.

15. Dispositif d'alimentation enfichable selon la revendication 14, **caractérisé en ce que** le nombre d'impulsions du capteur de rotation incrémentiel est identique au nombre de positions de transfert.

16. Dispositif d'alimentation enfichable selon la revendication 14, **caractérisé en ce que** le nombre d'impulsions du capteur de rotations incrémentiel est suffisamment grand pour un servo-fonctionnement du moteur d'entraînement (3, 3') et pour un positionnement précis de la roue à picots (6).

17. Dispositif d'alimentation enfichable selon l'une des revendications 1 à 16, **caractérisé en ce qu'**il est prévu d'autres éléments de transmission mécaniques qui relient le moteur d'entraînement (3, 3') à une feuille de recouvrement disposé sur le convoyeur à bande.

18. Dispositif d'alimentation enfichable selon la revendication 9, **caractérisé en ce que** le codeur a accès à une table de correction dans laquelle sont stockés les écarts géométriques de dents individuelles de la roue à picots qui sont déterminés lors d'un calibrage.
